(19) Europäisches Patentamt
European Patent Office
Office européen des brevets

(11) EP 4 063 119 A1

# (12) EUROPEAN PATENT APPLICATION
published in accordance with Art. 153(4) EPC

(43) Date of publication:
**28.09.2022 Bulletin 2022/39**

(21) Application number: **20890549.7**

(22) Date of filing: **06.11.2020**

(51) International Patent Classification (IPC):
***B41C 1/00*** *(2006.01)* ***G03F 7/00*** *(2006.01)*
***G03F 7/32*** *(2006.01)*

(52) Cooperative Patent Classification (CPC):
**B41C 1/00; G03F 7/00; G03F 7/32**

(86) International application number:
**PCT/JP2020/041504**

(87) International publication number:
**WO 2021/100496 (27.05.2021 Gazette 2021/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **21.11.2019 JP 2019210248**

(71) Applicant: **FUJIFILM Corporation**
**Tokyo 106-8620 (JP)**

(72) Inventors:
- **SHIRAKAWA Masato**
  **Haibara-gun, Shizuoka 421-0396 (JP)**
- **MURAKAMI Taira**
  **Haibara-gun, Shizuoka 421-0396 (JP)**

(74) Representative: **HGF**
**HGF Limited**
**1 City Walk**
**Leeds LS11 9DX (GB)**

## (54) AQUEOUS DEVELOPER SOLUTION FOR FLEXOGRAPHIC PRINTING PLATES, AQUEOUS DEVELOPER CONDENSATE FOR FLEXOGRAPHIC PRINTING PLATES, AND METHOD FOR PRODUCING FLEXOGRAPHIC PRINTING PLATE

(57) An object of the present invention is to provide an aqueous developer for a flexographic printing plate, which has excellent concentration suitability and good storage stability in a case of being made into a concentrated solution, an aqueous developing concentrated solution for a flexographic printing plate, and a manufacturing method of a flexographic printing plate using these. The aqueous developer for a flexographic printing plate of the present invention is an aqueous developer for a flexographic printing plate including an anionic surfactant, a nonionic surfactant, and water, in which the anionic surfactant is a compound represented by Formula (1).

$$R^1\text{-}X^1 \cdots \qquad (1)$$

Here, in Formula (1), $R^1$ represents an alkyl group having 3 to 20 carbon atoms, an alkenyl group having 3 to 20 carbon atoms, or an alkynyl group having 3 to 20 carbon atoms, which may have a substituent, and $X^1$ represents a carboxylic acid group or a salt of the carboxylic acid group, a sulfonic acid group or a salt of the sulfonic acid group, a sulfate group or a salt of the sulfate group, or a phosphoric acid group or a salt of the phosphoric acid group.

EP 4 063 119 A1

## Description

## BACKGROUND OF THE INVENTION

1. Field of the Invention

The present invention relates to an aqueous developer for a flexographic printing plate, an aqueous developing concentrated solution for a flexographic printing plate, and a manufacturing method of a flexographic printing plate using these.

2. Description of the Related Art

In recent years, various industries have started to reduce the use of organic solvents from the viewpoint of improving the working environment and preserving the global environment, and in a plate making step of a photosensitive flexographic printing plate used for printing, the use of an aqueous developable photosensitive resin plate is increasing.

For example, WO2012/111238A discloses a "developer composition for a printing plate containing: (a) alkali metal salt of saturated fatty acid having carbon number of 12 to 18 and (b) alkali metal salt of unsaturated fatty acid having carbon number of 12 to 18 in a weight ratio of from 20:80 to 80:20 in terms of (a):(b)" ([claim 1]).

## SUMMARY OF THE INVENTION

The present inventors have examined an aspect of using the aqueous developer disclosed in WO2012/111238A and the like as a concentrated solution from the viewpoint of reducing volume during storage and transportation, and have found that, depending on a type of a surfactant included in the aqueous developer, solubility or dispersibility of the surfactant may decrease in a case of being made into a concentrated solution, whereby concentration suitability deteriorates, and even in a case where the solubility of the surfactant is good in the case of being made into a concentrated solution, precipitation of the surfactant may occur over time, whereby storage stability deteriorates.

Therefore, an object of the present invention is to provide an aqueous developer for a flexographic printing plate, which has excellent concentration suitability and good storage stability in a case of being made into a concentrated solution, an aqueous developing concentrated solution for a flexographic printing plate, and a manufacturing method of a flexographic printing plate using these.

As a result of conducting intensive investigations to achieve the above-described object, the present inventors have found that an aqueous developer containing a nonionic surfactant together with a predetermined anionic surfactant has excellent concentration suitability and good storage stability in a case of being made into a concentrated solution, and thus completed the present invention.

That is, the present inventors have found that the above-described object can be achieved by adopting the following configurations.

[1] An aqueous developer for a flexographic printing plate comprising:

an anionic surfactant;
a nonionic surfactant; and
water,
in which the anionic surfactant is a compound represented by Formula (1),

$$R^1\text{-}X^1 \cdots \qquad (1)$$

here, in Formula (1),
$R^1$ represents an alkyl group having 3 to 20 carbon atoms, an alkenyl group having 3 to 20 carbon atoms, or an alkynyl group having 3 to 20 carbon atoms, which may have a substituent, and
$X^1$ represents a carboxylic acid group or a salt of the carboxylic acid group, a sulfonic acid group or a salt of the sulfonic acid group, a sulfate group or a salt of the sulfate group, or a phosphoric acid group or a salt of the phosphoric acid group.

[2] The aqueous developer for a flexographic printing plate according to [1],

in which a content of the anionic surfactant is 0.01% to 10% by mass, and

a content of the nonionic surfactant is 0.01% to 10% by mass.

[3] The aqueous developer for a flexographic printing plate according to [1] or [2], further comprising:
an alkali agent.
[4] The aqueous developer for a flexographic printing plate according to any one of [1] to [3],
in which $R^1$ in Formula (1) has 6 to 14 carbon atoms.
[5] The aqueous developer for a flexographic printing plate according to any one of [1] to [4],
in which the compound represented by Formula (1) has an HLB value of 8 or less and is water-soluble.
[6] The aqueous developer for a flexographic printing plate according to any one of [1] to [5],

in which the nonionic surfactant is a compound represented by Formula (2),

$$\left[X^2\right]_p Ar \left[O \left(AO\right)_n R^2\right]_{m-p} \quad (2)$$

here, in Formula (2),
Ar represents an m-valent aromatic group and m represents an integer of 1 to 8,
$X^2$ represents a monovalent organic group and p represents an integer of 0 to 3,
where p is smaller than m, and in a case where p is 2 or 3, a plurality of $X^2$'s may be the same or different from each other,
A represents an alkylene group having 2 to 4 carbon atoms, $R^2$ represents a hydrogen atom or an alkyl group, and n represents an integer of 1 to 100,
in a case where n is an integer of 2 to 100, a plurality of A's may be the same or different from each other, and in a case where m-p is an integer of 2 to 8, a plurality of A's, n's, and $R^2$'s may all be the same or different from each other.

[7] A manufacturing method of a flexographic printing plate having a non-image area and an image area, the manufacturing method comprising:

an exposure step of imagewise exposing a photosensitive layer in a flexographic printing plate precursor having the photosensitive layer;
a development step of, after the exposure step, performing development using the aqueous developer for a flexographic printing plate according to any one of [1] to [6] to form a non-image area and an image area; and
a rinse step of, after the development step, performing rinsing with water.

[8] An aqueous developing concentrated solution for a flexographic printing plate, which is a concentrated solution of an aqueous developer for a flexographic printing plate, comprising:

an anionic surfactant;
a nonionic surfactant; and
water.

[9] The aqueous developing concentrated solution for a flexographic printing plate according to [8],

in which a content of the anionic surfactant is 0.02% to 40% by mass, and
a content of the nonionic surfactant is 0.02% to 40% by mass.

[10] The aqueous developing concentrated solution for a flexographic printing plate according to [8] or [9], further comprising:
an alkali agent.
[11] The aqueous developing concentrated solution for a flexographic printing plate according to any one of [8] to [10],

in which the anionic surfactant is a compound represented by Formula (1),

$$R^1\text{-}X^1 \cdots \qquad (1)$$

here, in Formula (1),
$R^1$ represents an alkyl group having 3 to 20 carbon atoms, an alkenyl group having 3 to 20 carbon atoms, or an alkynyl group having 3 to 20 carbon atoms, which may have a substituent, and
$X^1$ represents a carboxylic acid group or a salt of the carboxylic acid group, a sulfonic acid group or a salt of the sulfonic acid group, a sulfate group or a salt of the sulfate group, or a phosphoric acid group or a salt of the phosphoric acid group.

[12] The aqueous developing concentrated solution for a flexographic printing plate according to [11], in which $R^1$ in Formula (1) has 6 to 14 carbon atoms.
[13] The aqueous developing concentrated solution for a flexographic printing plate according to [11] or [12], in which the compound represented by Formula (1) has an HLB value of 8 or less and is water-soluble.
[14] The aqueous developing concentrated solution for a flexographic printing plate according to any one of [8] to [13],

in which the nonionic surfactant is a compound represented by Formula (2),

$$\left[X^2\right]_p\!-\!Ar\!-\!\left[O\!-\!\left(AO\right)_n\!-\!R^2\right]_{m-p} \qquad (2)$$

here, in Formula (2),
Ar represents an m-valent aromatic group and m represents an integer of 1 to 8,
$X^2$ represents a monovalent organic group and p represents an integer of 0 to 3,
where p is smaller than m, and in a case where p is 2 or 3, a plurality of $X^2$'s may be the same or different from each other,
A represents an alkylene group having 2 to 4 carbon atoms, $R^2$ represents a hydrogen atom or an alkyl group, and n represents an integer of 1 to 100,
in a case where n is an integer of 2 to 100, a plurality of A's may be the same or different from each other, and in a case where m-p is an integer of 2 to 8, a plurality of A's, n's, and $R^2$'s may all be the same or different from each other.

[15] A manufacturing method of a flexographic printing plate having a non-image area and an image area, the manufacturing method comprising:

an exposure step of imagewise exposing a photosensitive layer in a flexographic printing plate precursor having the photosensitive layer;
a development step of, after the exposure step, performing development using a solution obtained by diluting the aqueous developing concentrated solution for a flexographic printing plate according to any one of [8] to [14] by 2 to 20 times to form a non-image area and an image area; and
a rinse step of, after the development step, performing rinsing with water.

According to the present invention, it is possible to provide an aqueous developer for a flexographic printing plate, which has excellent concentration suitability and good storage stability in a case of being made into a concentrated solution, an aqueous developing concentrated solution for a flexographic printing plate, and a manufacturing method of a flexographic printing plate using these.

## DESCRIPTION OF THE PREFERRED EMBODIMENTS

Hereinafter, the present invention will be described in detail.
The description of configuration requirements described below may be made on the basis of representative embodiments of the present invention, but it should not be construed that the present invention is limited to those embodiments.
In the specification of the present application, the numerical range expressed by using "to" means a range including the numerical values before and after "to" as the lower limit value and the upper limit value.
In addition, in this specification, for each component, one kind of substance corresponding to each component may be used alone, or two or more kinds thereof may be used in combination. Here, in a case where two or more kinds

of substances are used in combination for each component, the content of the component indicates the total content of the substances used in combination, unless otherwise specified.

[Aqueous developer for flexographic printing plate]

An aqueous developer for a flexographic printing plate according to an embodiment of the present invention (hereinafter, also abbreviated as a "developer according to the embodiment of the present invention") is an aqueous developer for a flexographic printing plate, containing an anionic surfactant, a nonionic surfactant, and water.

In addition, the anionic surfactant contained in the developer according to the embodiment of the present invention is a compound represented by Formula (1) described later.

In the present invention, as described above, the aqueous developer containing the nonionic surfactant together with the anionic surfactant represented by Formula (1) described later has excellent concentration suitability and good storage stability in a case of being made into a concentrated solution.

Although the details thereof are not clear, the present inventors have assumed as follows.

First, as shown in Comparative Examples 1 to 4 described later, it can be seen that, in a case where the nonionic surfactant is not formulated and only the anionic surfactant is formulated, the concentration suitability deteriorates.

In addition, as shown in Comparative Example 5 described later, it can be seen that, in a case where the anionic surfactant is not formulated and only the nonionic surfactant is formulated, the storage stability in a case of being made into a concentrated solution deteriorates.

Therefore, in the present invention, in a case where the nonionic surfactant is formulated together with the anionic surfactant represented by Formula (1) described later, compared to the case where each surfactant is formulated alone, dispersibility or solubility is improved due to an interaction of these surfactants, so that the concentration suitability is excellent and the storage stability in a case of being made into a concentrated solution is also good.

Hereinafter, each component contained in the developer according to the embodiment of the present invention will be described in detail.

[Anionic surfactant]

The anionic surfactant contained in the developer according to the embodiment of the present invention is a compound represented by Formula (1).

$$R^1\text{-}X^1 \cdots \qquad (1)$$

In Formula (1), $R^1$ represents an alkyl group having 3 to 20 carbon atoms, an alkenyl group having 3 to 20 carbon atoms, or an alkynyl group having 3 to 20 carbon atoms, which may have a substituent.

In addition, in Formula (1), $X^1$ represents a carboxylic acid group or a salt of the carboxylic acid group, a sulfonic acid group or a salt of the sulfonic acid group, a sulfate group or a salt of the sulfate group, or a phosphoric acid group or a salt of the phosphoric acid group.

The alkyl group having 3 to 20 carbon atoms, which represents one aspect of $R^1$ in Formula (1), may be linear, branched, or cyclic, and specific examples thereof include a methyl group, an ethyl group, a propyl group, a butyl group, a hexyl group, a 2-ethylhexyl group, an octyl group, a decyl group, a dodecyl group, a hexadecyl group, a stearyl group, a cyclohexyl group, and a cyclooctyl group.

The alkenyl group having 3 to 20 carbon atoms, which represents one aspect of $R^1$ in Formula (1), may be linear, branched, or cyclic, and specific examples thereof include a 1-propenyl group, a 1-butenyl group, a 1-methyl-1-propenyl group, a 1-hexenyl group, a 2-hexenyl group, a 3-hexenyl group, a 4-hexenyl group, a 5-hexenyl group, and a cyclohexenyl group.

The alkynyl group having 3 to 20 carbon atoms, which represents one aspect of $R^1$ in Formula (1), may be linear, branched, or cyclic, and specific examples thereof include a 1-propynyl group, a 1-butynyl group, a 1-octynyl group, a 1-decynyl group, and a 1-octadecynyl group.

In addition, as the substituent which may be included in $R^1$ in Formula (1), a monovalent nonmetallic atomic group excluding a hydrogen atom is used, and examples thereof include a halogen atom (F, Cl, Br, or I), a hydroxy group, an alkoxy group, an aryloxy group, an acyl group, an amide group, an ester group, an acyloxy group, a carboxy group, a carboxylic acid anion group, and a sulfonic acid anion group.

Specific examples of the alkoxy group include a methoxy group, an ethoxy group, a propyloxy group, an isopropyloxy group, a butyloxy group, a pentyloxy group, a hexyloxy group, a dodecyloxy group, a stearyloxy group, a methoxyethoxy group, a poly(ethyleneoxy) group, and a poly(propyleneoxy) group, which preferably have 1 to 40 carbon atoms and more preferably have 1 to 20 carbon atoms.

Specific examples of the aryloxy group include a phenoxy group, a tolyloxy group, a xylyloxy group, a mesityloxy

group, a cumenyloxy group, a methoxyphenyloxy group, an ethoxyphenyloxy group, a chlorophenyloxy group, a bromophenyloxy group, and a naphthyloxy group, which have 6 to 18 carbon atoms.

Specific examples of the acyl group include an acetyl group, a propanoyl group, a butanoyl group, a benzoyl group, and a naphthoyl group, which have 2 to 24 carbon atoms.

Specific examples of the amide group include an acetamide group, a propionic acid amide group, a dodecanoic acid amide group, a palmitic acid amide group, a stearic acid amide group, a benzoic acid amide group, and a naphthoic acid amide group, which have 2 to 24 carbon atoms.

Specific examples of the acyloxy group include an acetoxy group, a propanoyloxy group, a benzoyloxy group, and a naphthoyloxy group, which have 2 to 20 carbon atoms.

Specific examples of the ester group include a methyl ester group, an ethyl ester group, a propyl ester group, a hexyl ester group, an octyl ester group, a dodecyl ester group, and a stearyl ester group, which have 1 to 24 carbon atoms.

The substituent may consist of a combination of two or more substituents described above.

In the present invention, with regard to the developer according to the embodiment of the present invention, from the reason that a formation of a coating on a solution surface can be suppressed, it is preferable that $R^1$ in Formula (1) has 6 to 14 carbon atoms. Specifically, it is more preferable that $R^1$ in Formula (1) is an alkyl group having 6 to 14 carbon atoms, and in a development using the developer according to the embodiment of the present invention, from the reason that an aggregation of developing residue (dispersion) can be suppressed, it is still more preferable to be an alkyl group having 6 to 10 carbon atoms.

As described above, $X^1$ in Formula (1) represents a carboxylic acid group (-COOH) or a salt of the carboxylic acid group, a sulfonic acid group ($-SO_3H$) or a salt of the sulfonic acid group, a sulfate group ($-OSO_3H$) or a salt the sulfate group, or a phosphoric acid group ($-OPO_3H_2$) or a salt of the phosphoric acid group, and among these, a carboxylic acid group or a salt of the carboxylic acid group, a sulfonic acid group or a salt of the sulfonic acid group, or a phosphoric acid group or a salt the phosphoric acid group is preferable, and a carboxylic acid group or a salt of the carboxylic acid group is more preferable.

In addition, the salt of the carboxylic acid group and the like is preferably an alkali metal salt such as a sodium salt and a potassium salt.

In the present invention, with regard to the developer according to the embodiment of the present invention, from the reason that a formation of a coating on a solution surface can be suppressed, it is preferable that the compound represented by Formula (1) has an HLB value of 8 or less and is water-soluble.

In addition, it is preferable that the compound represented by Formula (1) has an HLB value of 3 or more.

Here, the hydrophile lipophile balance (HLB) value in the present invention refers to a value calculated by the following expression (HL) in a case where a molecular weight of the compound represented by Formula (1) is defined as M and a molecular weight of $X^1$ in Formula (1) is defined as Mw.

$$\text{HLB value} = 20 \times Mw/M \cdots \text{(HL)}$$

In addition, in the present invention, the "water-soluble" means that, in a case where the compound represented by Formula (1) is dried at 105°C for 2 hours and then dissolved in 100 g of water at 40°C, insoluble matter cannot be visually confirmed within 3 hours.

In the present invention, a content of the anionic surfactant is preferably 0.01% to 10% by mass and more preferably 0.1% to 2% by mass with respect to a total mass of the developer according to the embodiment of the present invention.

[Nonionic surfactant]

The nonionic surfactant contained in the developer according to the embodiment of the present invention is not particularly limited, and a known nonionic surfactant in the related art can be used.

Examples of the nonionic surfactant include polyoxyethylene alkyl ethers, polyoxyethylene alkyl phenyl ethers, polyoxyethylene polystyrylphenyl ether, glycerin fatty acid partial esters, sorbitan fatty acid partial esters, pentaerythritol fatty acid partial esters, propylene glycol monofatty acid ester, sucrose fatty acid partial ester, polyoxyethylene sorbitan fatty acid partial esters, polyoxyethylene sorbitol fatty acid partial esters, polyethylene glycol fatty acid esters, polyglycerin fatty acid partial esters, polyoxyethylene glycerin fatty acid partial esters, polyoxyethylene diglycerins, fatty acid diethanolamides, N,N-bis-2-hydroxyalkylamines, polyoxyethylene alkylamine, triethanolamine fatty acid ester, trialkylamine oxide, polyoxyethylene alkyl phenyl ethers, and polyoxyethylene-polyoxypropylene block copolymers.

In the present invention, from the reason that the storage stability in a case of being made into a concentrated solution is better, and in the development using the developer according to the embodiment of the present invention, from the reason that the aggregation of developing residue (dispersion) can be suppressed, the nonionic surfactant is

preferably a compound represented by Formula (2).

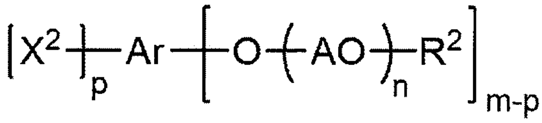

(2)

In Formula (2), Ar represents an m-valent aromatic group and m represents an integer of 1 to 8.

In addition, in Formula (2), $X^2$ represents a monovalent organic group and p represents an integer of 0 to 3. However, p is smaller than m, and in a case where p is 2 or 3, a plurality of $X^2$'s may be the same or different from each other.

In addition, in Formula (2), A represents an alkylene group having 2 to 4 carbon atoms, $R^2$ represents a hydrogen atom or an alkyl group, and n represents an integer of 1 to 100. In a case where n is an integer of 2 to 100, a plurality of A's may be the same or different from each other. In a case where m-p is an integer of 2 to 8, a plurality of A's, n's, and $R^2$'s may all be the same or different from each other.

The aromatic group represented by Ar in Formula (2) refers to a group which includes a ring having aromaticity, and examples thereof include m-valent groups having at least one aromatic ring selected from the group consisting of an aromatic hydrocarbon ring and an aromatic heterocyclic ring.

Here, examples of the aromatic hydrocarbon ring include a benzene ring, a naphthalene ring, an anthracene ring, and a phenanthroline ring, and examples of the aromatic heterocyclic ring include a furan ring, a pyrrole ring, a thiophene ring, a pyridine ring, a thiazole ring, and a benzothiazole ring.

In addition, the valence (m) of the aromatic group represented by Ar in Formula (2) is an integer of 1 to 8, preferably an integer of 2 to 6, more preferably an integer of 2 to 4, and still more preferably 2 or 3.

Among these, as Ar, a divalent benzene ring (that is, a phenylene group) or a monovalent naphthalene ring (that is, a naphthyl group) is preferable, and a phenylene group is more preferable.

Examples of the monovalent organic group represented by $X^2$ in Formula (2) include an alkyl group, a cycloalkyl group, an aryl group, an aralkyl group, and an alkenyl group, and these groups may further have a substituent.

Examples of the alkyl group include a linear or branched alkyl group having 1 to 18 carbon atoms, and specific examples thereof include a methyl group, an ethyl group, a propyl group, a butyl group, a pentyl group, a tert-pentyl group, and an n-hexyl group.

Examples of the cycloalkyl group include a monocyclic or polycyclic cycloalkyl group having 3 to 20 carbon atoms, and specific examples thereof include a cyclopentyl group, a cyclopentylmethyl group, a cyclopentylethyl group, a cyclohexyl group, a cyclohexylmethyl group, and a cyclohexylethyl group.

Examples of the aryl group include an aryl group having 6 to 14 carbon atoms, and specific examples thereof include a phenyl group, a methylphenyl group, a tolyl group, a xylyl group, a naphthyl group, an anthryl group, a phenanthryl group, and a pyrenyl group.

Examples of the aralkyl group include an aralkyl group having 7 to 20 carbon atoms, and specific examples thereof include a benzyl group, a phenethyl group, a 2-phenylethan-2-yl group, and a naphthylmethyl group.

Examples of the alkenyl group include an alkenyl group having 3 to 20 carbon atoms, and specific examples thereof include a vinyl group and an allyl group.

Among these organic groups, from the reason that the aggregation of the dispersion can be further suppressed, $X^2$ in Formula (2) is preferably an aralkyl group, and more preferably a 2-phenylethan-2-yl group or a benzyl group.

Structures of the 2-phenylethan-2-yl group and the benzyl group are as shown in Formulae (X-1) and (X-2) described below, and the structure represented by Formula (X-1) (2-phenylethan-2-yl group) is also referred to as "styrenated" or "styryl group".

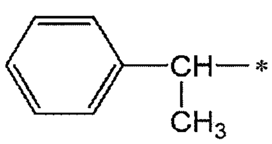

(X-1)

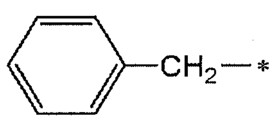

(X-2)

p in Formula (2) represents an integer of 0 to 3, and is smaller than m. In the development using the developer according to the embodiment of the present invention, from the reason that the aggregation of developing residue can be suppressed, p preferably represents an integer of 1 to 3 and more preferably 1 or 2.

A in Formula (2) represents an alkylene group having 2 to 4 carbon atoms, and is preferably an alkylene group having 2 or 3 carbon atoms and more preferably an ethylene group or an n-propylene group.

As the alkyl group which represents one aspect of $R^2$ in Formula (2), an alkyl group having 1 to 6 carbon atoms

is preferable, and an alkyl group having 1 to 4 carbon atoms is more preferable. Specific examples thereof include a methyl group, an ethyl group, a propyl group, and an n-butyl group.

$R^2$ in Formula (2) represents a hydrogen atom or an alkyl group, and in the development using the developer according to the embodiment of the present invention, from the reason that the aggregation of developing residue can be suppressed, it is preferable to be a hydrogen atom.

n in Formula (2) represents an integer of 1 to 100, and in the development using the developer according to the embodiment of the present invention, from the reason that the aggregation of developing residue can be suppressed, it is preferable to be an integer of 1 to 30, more preferably to be an integer of 5 to 20, and still more preferable to be an integer of 5 to 15.

Specific examples of the compound represented by Formula (2) (nonionic surfactant) include:

polyoxyalkylene polystyrylphenyl ethers such as polyoxyethylene styrenated phenyl ether, polyoxyethylene polystyrylphenyl ether, polyoxyethylene distyrenated phenyl ether, polyoxyethylene tristylylphenyl ether represented by Formula (2-1), polyoxyethylene styrenated phenyl ether ammonium sulfate, and polyoxyethylene polystyrylphenyl ether condensate; and

polyoxyethylene dodecylphenyl ether, polyoxyethylene phenyl ether, polyoxyethylene benzyl ether, polyoxyethylene β-naphthyl ether, polyoxyethylene bisphenol A ether, polyoxyethylene bisphenol F ether, polyoxyethylene cumylphenyl ether, polyoxyethylene naphthyl ether, polyoxyethylene tribenzylphenyl ether, polyoxyethylene aryl ether, polyoxyethylene polycyclic phenyl ether, and polyoxyalkylene polycyclic phenyl ether.

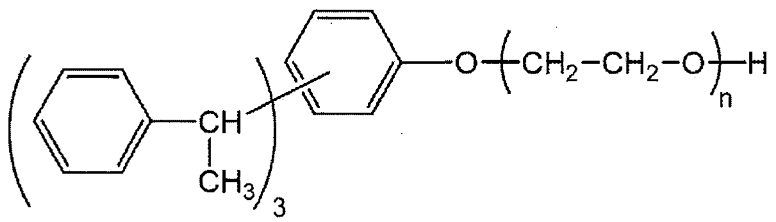

(2-1)

In the present invention, a content of the nonionic surfactant is preferably 0.01% to 10% by mass and more preferably 0.1% to 2% by mass with respect to the total mass of the developer according to the embodiment of the present invention.

[Water]

The water contained in the developer according to the embodiment of the present invention is not particularly limited, and any of purified water, distilled water, ion exchange water, pure water, or ultrapure water such as Milli-Q water can be used. The Milli-Q water is ultrapure water obtained by a Milli-Q water production device, which is an ultrapure water production device manufactured by Merck KGaA.

A content of the water contained in the developer according to the embodiment of the present invention is preferably 80% to 99.99% by mass and more preferably 90% to 99.9% by mass with respect to the total mass of the developer.

[Alkali agent]

From the reason that the developability is good, it is preferable that the developer according to the embodiment of the present invention contains an alkali agent.

Examples of the alkali agent include an alkali metal carbonate and an alkali metal hydroxide.

Here, specific examples of the alkali metal include sodium, potassium, and calcium.

In addition, specific examples of the alkali metal carbonate include sodium carbonate, and potassium carbonate, and among these, sodium carbonate is preferable from the viewpoint of safety.

In addition, specific examples of the alkali metal hydroxide include sodium hydroxide and potassium hydroxide.

In a case of containing an alkali agent, the content thereof is preferably 0.01% to 2% by mass and more preferably 0.1% to 0.5% by mass with respect to the total mass of the developer according to the embodiment of the present invention.

[Chelating agent]

From the reason that the aggregation of developing residue can be suppressed, it is preferable that the developer

according to the embodiment of the present invention contains a chelating agent.

Specific examples of the chelating agent include citric acid, ethylenediaminetetraacetic acid (EDTA), ethylenediamine-N,N'-disuccinic acid (EDDS), L-glutamate diacetic acid (GLDA), and an alkali metal salt thereof.

[Other components]

In the developer according to the embodiment of the present invention, various additives may be formulated as optional components, as required.

Examples of the additives include alkanolamine such as ethanolamine; preservatives such as benzotriazole and benzoic acid; freezing point depressants such as glycols (for example, ethylene glycol) and lower alcohols (for example, ethanol); and antifoaming agents such as silicones and polyols, and these can be appropriately formulated within a range which does not impair the effects of the present invention.

[Development method]

As a development method using the developer according to the embodiment of the present invention, the same method as a developing method using a known aqueous developer in the related art may be used, and examples thereof include a method of bringing a developer into contact with a non-exposed area of a flexographic printing plate precursor, applying a physical action of a brush, water pressure, supersonic waves, or the like, and dispersing a photosensitive layer (photosensitive resin composition) that constitutes the non-exposed area in the developer to remove the photosensitive layer.

In this case, the non-exposed area may be immersed in the developer, or the developer may be continuously supplied and brought into contact with the non-exposed area in a case where a physical action is exerted.

In addition, a liquid temperature of the developer during development is preferably 20°C to 60°C and more preferably 30°C to 50°C.

In addition, a brush is used for the physical action force usually used, and the material, thickness, and length of bristles, denseness and arrangement of bristles, movement and rotation direction of brush, and the like are appropriately selected.

[Aqueous developing concentrated solution for flexographic printing plate]

An aqueous developing concentrated solution for a flexographic printing plate according to an embodiment of the present invention (hereinafter, also abbreviated as a "concentrated solution according to the embodiment of the present invention") is a concentrated solution of an aqueous developer for a flexographic printing plate, containing an anionic surfactant, a nonionic surfactant, and water.

[Anionic surfactant]

The anionic surfactant contained in the concentrated solution according to the embodiment of the present invention is not particularly limited, and a known anionic surfactant in the related art can be used.

Examples of the anion-type surfactant include fatty acid salts, abietic acid salts, hydroxyalkanesulfonic acid salts, alkanesulfonic acid salts, dialkylsulfosuccinic acid salts, linear alkylbenzenesulfonic acid salts, branched alkylbenzene sulfonates, alkylnaphthalene sulfonates, alkylphenoxy polyoxyethylene propyl sulfonates, polyoxyethylene alkyl sulfophenyl ether salts, N-methyl-N-oleyl taurine sodiums, N-alkylsulfosuccinic acid monoamide disodium salts, petroleum sulfonates, sulfated castor oil, sulfated beef tallow oil, sulfate salts of fatty acid alkyl esters, alkyl sulfate ester salts, polyoxyethylene alkyl ether sulfate ester salts, fatty acid monoglyceride sulfate ester salts, polyoxyethylene alkylphenyl ether sulfate ester salts, polyoxyethylene styrylphenyl ether sulfate ester salts, alkyl phosphate ester salts, polyoxyethylene alkyl ether phosphate ester salts, polyoxyethylene alkylphenyl ether phosphate ester salts, partially saponified styrene-maleic acid anhydride copolymers, partially saponified olefin-maleic acid anhydride copolymers, and naphthalene sulfonate formalin condensates.

In the present invention, with regard to a developer prepared by diluting the concentrated solution according to the embodiment of the present invention, from the reason that a formation of a coating on a solution surface can be suppressed, it is preferable that the anionic surfactant is the compound represented by Formula (1) described above.

In the present invention, with regard to the developer prepared by diluting the concentrated solution according to the embodiment of the present invention, from the reason that the formation of a coating on a solution surface can be suppressed, it is preferable that $R^1$ in Formula (1) has 6 to 14 carbon atoms. Specifically, it is more preferable that $R^1$ in Formula (1) is an alkyl group having 6 to 14 carbon atoms, and in a development using the developer prepared by diluting the concentrated solution according to the embodiment of the present invention, from the reason that an

aggregation of developing residue (dispersion) can be suppressed, it is still more preferable to be an alkyl group having 6 to 10 carbon atoms.

In the present invention, with regard to the developer prepared by diluting the concentrated solution according to the embodiment of the present invention, from the reason that a formation of a coating on a solution surface can be suppressed, it is preferable that the compound represented by Formula (1) has an HLB value of 8 or less and is water-soluble.

In addition, it is preferable that the compound represented by Formula (1) has an HLB value of 3 or more.

In the present invention, a content of the anionic surfactant is preferably 0.02% to 40% by mass and more preferably 3% to 25% by mass with respect to a total mass of the concentrated solution according to the embodiment of the present invention.

[Nonionic surfactant]

The nonionic surfactant contained in the concentrated solution according to the embodiment of the present invention is not particularly limited, and the nonionic surfactant described in the developer according to the embodiment of the present invention described above can be used.

In the present invention, from the reason that the storage stability is better, and in the development using the developer prepared by diluting the concentrated solution according to the embodiment of the present invention, from the reason that the aggregation of developing residue (dispersion) can be suppressed, the nonionic surfactant is preferably a compound represented by Formula (2) described above.

In the present invention, a content of the nonionic surfactant is preferably 0.02% to 40% by mass and more preferably 3% to 25% by mass with respect to a total mass of the concentrated solution according to the embodiment of the present invention.

[Water]

The water contained in the concentrated solution according to the embodiment of the present invention is not particularly limited, and the water described in the developer according to the embodiment of the present invention described above can be used.

A content of the water contained in the concentrated solution according to the embodiment of the present invention is not particularly limited because it can be adjusted by the degree of concentration, but is preferably less than 80% by mass and more preferably 50% by mass or more and less than 80% by mass with respect to the total mass of the concentrated solution according to the embodiment of the present invention.

[Alkali agent]

From the reason that developability in a case of using the developer prepared by diluting the concentrated solution according to the embodiment of the present invention is good, it is preferable that the concentrated solution according to the embodiment of the present invention contains an alkali agent.

The alkali agent is not particularly limited, and the alkali agent described in the developer according to the embodiment of the present invention described above can be used.

In addition, in a case of containing an alkali agent, the content thereof is preferably 0.1% to 10% by mass and more preferably 1% to 5% by mass with respect to the total mass of the concentrated solution according to the embodiment of the present invention.

[Chelating agent]

In the development using the developer prepared by diluting the concentrated solution according to the embodiment of the present invention, from the reason that the aggregation of developing residue can be suppressed, it is preferable that the concentrated solution according to the embodiment of the present invention contains a chelating agent.

The chelating agent is not particularly limited, and the chelating agent described in the developer according to the embodiment of the present invention described above can be used.

[Other components]

In the concentrated solution according to the embodiment of the present invention, various additives may be formulated as optional components, as required.

Examples of the additives include alkanolamine such as ethanolamine; preservatives such as benzotriazole

and benzoic acid; freezing point depressants such as glycols (for example, ethylene glycol) and lower alcohols (for example, ethanol); and antifoaming agents such as silicones and polyols, and these can be appropriately formulated within a range which does not impair the effects of the present invention.

[Development method]

As a development method using the concentrated solution according to the embodiment of the present invention, the same method as a developing method using a known aqueous developer in the related art, except that an aqueous developer obtained by diluting the concentrated solution according to the embodiment of the present invention is used, may be used, and examples thereof include a method of bringing an aqueous developer into contact with a non-exposed area of a flexographic printing plate precursor, applying a physical action of a brush, water pressure, supersonic waves, or the like, and dispersing a photosensitive layer (photosensitive resin composition) that constitutes the non-exposed area in the aqueous developer to remove the photosensitive layer.

Here, a method for diluting the concentrated solution according to the embodiment of the present invention is not particularly limited, and examples thereof include a method of diluting the concentrated solution according to the embodiment of the present invention by 2 to 20 times with water.

In this case, the non-exposed area may be immersed in the aqueous developer, or the aqueous developer may be continuously supplied and brought into contact with the non-exposed area in a case where a physical action is exerted.

In addition, the liquid temperature of the aqueous developer during development is preferably 20°C to 60°C and more preferably 30°C to 50°C.

In addition, a brush is used for the physical action force usually used, and the material, thickness, and length of bristles, deneseness and arrangement of bristles, movement and rotation direction of brush, and the like are appropriately selected.

[Flexographic printing plate precursor]

For the photosensitive layer (photosensitive resin composition) of the flexographic printing plate precursor developed with the developer or concentrated solution according to the embodiment of the present invention, a known photosensitive resin composition in the related art can be used. Examples thereof include a resin composition containing a water-dispersible latex, rubber, a photopolymerizable monomer, a photopolymerization initiator, and a surfactant.

<Water-dispersible latex>

The water-dispersible latex contained in the resin composition is not particularly limited, and water-dispersible latexes used in a known flexographic printing plate in the related art can be used.

Specific examples of the water-dispersible latex include water-dispersible latex polymers such as polybutadiene latex, natural rubber latex, styrene-butadiene copolymer latex, acrylonitrile-butadiene copolymer latex, polychloroprene latex, polyisoprene latex, polyurethane latex, methylmethacrylate-butadiene copolymer latex, vinylpyridine polymer latex, butyl polymer latex, Thiokol polymer latex, and acrylate polymer latex; and polymers obtained by copolymerizing another component, such as acrylic acid and methacrylic acid, therewith. These may be used alone or in combination of two or more.

<Rubber>

The rubber contained in the resin composition is not particularly limited, and rubber materials used in a known flexographic printing plate in the related art can be used.

Specific examples of the rubber include butadiene rubber (BR), nitrile rubber (NBR), acrylic rubber, epichlorohydrin rubber, urethane rubber, isoprene rubber, styrene isoprene rubber, styrene butadiene rubber, ethylene-propylene copolymer, and chlorinated polyethylene. These may be used alone or in combination of two or more.

<Photopolymerizable monomer>

The photopolymerizable monomer contained in the resin composition is not particularly limited, and photopolymerizable monomers used in a known flexographic printing plate in the related art can be used.

Examples of the photopolymerizable monomer include ethylenically unsaturated compounds.

Specific examples of the ethylenically unsaturated compound include (meth)acrylic monomers, (meth)acrylic oligomers, and (meth)acrylic modified polymers.

In addition, specific examples of the (meth)acrylic modified polymer include (meth)acrylic modified butadiene rubber and (meth)acrylic modified nitrile rubber.
The term "(meth)acrylic" is a notation meaning acrylic or methacrylic.

<Photopolymerization initiator>

The photopolymerization initiator contained in the resin composition is not particularly limited as long as the photopolymerization of the above-described photopolymerizable monomer is initiated, and examples thereof include photopolymerization initiators such as alkylphenones, acetophenones, benzoin ethers, benzophenones, thioxanthones, anthraquinones, benzils, and biacetyls.
Specific examples thereof include benzyl dimethyl ketal, 2-hydroxy-2-methyl-1-phenyl-propane-1-one, methyl-o-benzoylbenzoate, and 1-hydroxycyclohexyl phenyl ketone.

<Surfactant>

From the viewpoint of improving water developability, the resin composition contained in the resin composition preferably contains a surfactant.
Examples of the surfactant include a cationic surfactant, an anionic surfactant, and a nonionic surfactant. Among these, an anionic surfactant is preferable.
Specific examples of the anionic surfactant include:

aliphatic carboxylates such as sodium laurate, and sodium oleate;
higher alcohol sulfate ester salts such as sodium lauryl sulfate, sodium cetyl sulfate, and sodium oleyl sulfate;
polyoxyethylene alkyl ether sulfate ester salts such as sodium polyoxyethylene lauryl ether sulfate;
polyoxyethylene alkyl allyl ether sulfate ester salts such as sodium polyoxyethylene octyl phenyl ether sulfate and sodium polyoxyethylene nonyl phenyl ether sulfate;
alkyl sulfonates such as alkyl diphenyl ether disulfonate, sodium dodecyl sulfonate, and sodium dialkyl sulfosuccinate;
alkyl allyl sulfonates such as alkyl disulfonate, sodium dodecyl benzene sulfonate, sodium dibutyl naphthalene sulfonate, and sodium triisopropyl naphthalene sulfonate;
higher alcohol phosphate ester salts such as disodium lauryl phosphate monoester, and sodium lauryl phosphate diester; and
polyoxyethylene alkyl ether phosphate ester salts such as disodium polyoxyethylene lauryl ether phosphate monoester, and sodium polyoxyethylene lauryl ether phosphate diester.

These may be used alone or in combination of two or more.

[Manufacturing method of flexographic printing plate]

A manufacturing method of a flexographic printing plate according to an embodiment of the present invention includes an exposure step of imagewise exposing a photosensitive layer in a flexographic printing plate precursor having the photosensitive layer, a development step of, after the exposure step, performing development using the above-described aqueous developer for a flexographic printing plate according to the embodiment of the present invention, or using a solution obtained by diluting the above-described aqueous developing concentrated solution for a flexographic printing plate according to the embodiment of the present invention by 2 to 20 times to form a non-image area and an image area, and a rinse step of, after the development step, performing rinsing with water.

[Exposure step]

The exposure step is a step of imagewise irradiating the photosensitive layer with an actinic ray to induce crosslinking and/or polymerization of a region irradiated with the actinic ray and to cure the region.
The above-described exposure step can be performed by exposing the photosensitive layer through a mask provided on an outer surface side of the photosensitive layer.
In addition, it is also preferable to perform the exposure using a vacuum frame exposure device, and in this case, after the air between a relief forming layer and the mask is exhausted, the exposure with an actinic ray is performed.
In addition, the exposure may be performed in a state in which the oxygen concentration is lowered, or may be performed in the atmosphere. Although not particularly limited, from the viewpoint of preventing polymerization inhibition by oxygen, it is preferable that the exposure is performed at a low oxygen concentration.

[Development step]

The development step is a step of performing developing using the above-described aqueous developer for a flexographic printing plate according to the embodiment of the present invention, or using a solution obtained by diluting the above-described aqueous developing concentrated solution for a flexographic printing plate according to the embodiment of the present invention by 2 to 20 times to form a non-image area and an image area, and the details are as described in the above-described development method of developing the developer or concentrated solution according to the embodiment of the present invention.

[Rinse step]

The rinse step is a step of rinsing surfaces of the non-image area and the image area formed in the development step with water.

As a rinsing method in the rinse step, a method of washing with tap water, a method of spraying high pressure water, a method of rubbing the surfaces of the non-image area and the image area with a brush using a batch-type or transport-type brush type washing machine as a developing machine for flexographic printing plates mainly in the presence of water, and the like may be used.

Examples

Hereinafter, the present invention will be described in more detail with reference to examples. Materials, amounts used, ratios, treatment contents, treatment procedures, and the like shown in the following examples can be appropriately changed without departing from the spirit of the present invention. Therefore, the scope of the present invention should not be construed as being limited by the following examples.

[Examples 1 to 11 and Comparative Examples 1 to 5]

Each water, alkali agent, chelating agent, anionic surfactant, and nonionic surfactant shown in Table 1 below were formulated to have parts by mass shown in Table 1 below, thereby preparing aqueous developers.

[Concentration suitability]

Regarding an aqueous developing concentrated solution obtained by concentrating the concentration of the alkali agent and the like in the prepared aqueous developer 10 times, a dissolved state at room temperature (23°C) was visually observed and evaluated according to the following standard. The results are shown in Table 1 below. In a case where the evaluation is B or more, there is no practical problem.

(Evaluation standard)

A: colorless and transparent
B: turbidity
C: two-layer separation
D: insoluble precipitate

[Storage stability]

<50°C and 45 days>

The aqueous developing concentrated solution used in the evaluation of concentration suitability was stored in an oven at 50°C for 45 days, and then a liquid state was visually observed and evaluated according to the following standard. The results are shown in Table 1 below. In a case where the evaluation is B or more, there is no practical problem. In addition, in Comparative Examples 1 to 4, since insoluble matter was generated in the state before storage, the evaluation was not performed, and in Table 1 below, it is indicated as "-".

(Evaluation standard)

A: colorless and transparent
B: turbidity
C: two-layer separation

<-5°C and 60 days>

The aqueous developing concentrated solution used in the evaluation of concentration suitability was stored in a freezer at -5°C for 60 days, and then a liquid state was visually observed.

In addition, in a case where the evaluation solution was frozen, a time until remelting was measured.

The evaluation was performed according to the following standard. The results are shown in Table 1 below. In a case where the evaluation is B or more, there is no practical problem. In addition, in Comparative Examples 1 to 4, since two layers were separated in the state before storage, the evaluation was not performed, and in Table 1 below, it is indicated as "-".

(Evaluation standard)

A: solution was not frozen
B: it took less than 6 hours to remelt after leaving the freezer.
C: it took 6 hours or more to remelt after leaving the freezer.

[Developability]

A cover film of a flexographic printing plate precursor [FLENEX FW-L2, manufactured by FUJIFILM Corporation] was peeled off, and the flexographic printing plate precursor was exposed with an exposure device in which 15 40 W chemical lamps were arranged for 2 seconds from a substrate side from a distance of 15 cm (back exposure).

Thereafter, development was performed for 3 minutes with a brush type washing machine (liquid temperature: 50°C) containing each of the prepared aqueous developers.

Thereafter, the obtained flexographic printing plate was dried with hot air of 60°C until the moisture was removed. The thickness of the obtained flexographic printing plate was measured using a constant pressure thickness measuring device, and the change in film thickness per minute (development speed) was calculated from the change in thickness before and after development. The evaluation was performed according to the following standard. The results are shown in Table 1 below. In a case where the evaluation is B or more, there is no practical problem.

(Evaluation standard)

A: development speed was 170 μm/min or more.
B: development speed was 100 μm/min or more and less than 170 μm/min.
C: development speed was less than 100 μm/min.

[Aggregate residue]

A cover film of a flexographic printing plate precursor [FLENEX FW-L2, manufactured by FUJIFILM Corporation] was peeled off, and the flexographic printing plate precursor was exposed with an exposure device in which 15 40 W chemical lamps were arranged for 2 seconds from a substrate side from a distance of 15 cm (back exposure).

Thereafter, with a brush type washing machine (liquid temperature: 50°C) containing each of the prepared aqueous developers, development was performed for an optional time so that the solid content of a developing residue (dispersion) was 7.0% by mass. The solid content of the developing residue was obtained by measuring 2.0 g of the aqueous developer used (hereinafter, also abbreviated as a "fatigue solution"), drying at 95°C for 18 hours, and calculating solid content% in the fatigue solution from the weight change before and after drying.

Next, 7 g of the fatigue solution was measured in a container, 63 g of hard water having a hardness of 120 was

added thereto to dilute the solution, and aggregate residue generated immediately after stirring was observed and evaluated according to the following standard. The results are shown in Table 1 below. In a case where the evaluation is B or more, there is no practical problem.

(Evaluation standard)

A: no aggregate was generated, and no attachment was generated at a gas-liquid interface of the container.
B: no aggregate was generated, and attachment was generated at a gas-liquid interface of the container.
C: aggregates were generated.

[Coating suppression]

A cover film of a flexographic printing plate precursor [FLENEX FW-L2, manufactured by FUJIFILM Corporation] was peeled off, and the flexographic printing plate precursor was exposed with an exposure device in which 15 40 W chemical lamps were arranged for 2 seconds from a substrate side from a distance of 15 cm (back exposure).

Thereafter, with a brush type washing machine (liquid temperature: 50°C) containing each of the prepared aqueous developers, development was performed for an optional time so that the solid content of a developing residue (dispersion) was 7.0% by mass. The solid content of the developing residue was obtained by measuring 2.0 g of the aqueous developer used (hereinafter, also abbreviated as a "fatigue solution"), drying at 95°C for 18 hours, and calculating solid content% in the fatigue solution from the weight change before and after drying.

Next, 50 g of the fatigue solution was measured in a container and heated in an oven at 50°C for 5 hours with the lid opened, and after being left at room temperature (23°C) for 12 hours, a film hardness on a solution surface was visually observed and evaluated according to the following standard. The results are shown in Table 1 below. In a case where the evaluation is B or more, there is no practical problem.

(Evaluation standard)

A: no coating formation
B: coating was formed, but it could be redispersed after stirring.
C: coating was formed and did not redisperse even in a case of stirring.

[Table 1]

| | Composition of aqueous developer | | | | | | | | | | | Concentration suitability (concentration 10 times) | Storage stability | | Developability | Aggregate residue | Coating suppression |
|---|---|---|---|---|---|---|---|---|---|---|---|---|---|---|---|---|---|
| | Water | | Alkali agent | | Chelating agent | | Anionic surfactant | | | Nonionic surfactant | | | | | | | |
| | Type | % by mass | Type | % by mass | Type | % by mass | Type | %by mass | HLB value | Type | % by mass | | 50°C/ 45 davs | -5°C/ 60 davs | | | |
| Example 1 | Pure water | 97.4 | None | - | EDDS | 0.4 | Sodium pentanate | 1.2 | 8.8 | Pionin D-6120 | 1 | A | A | A | B | A | c |
| Example 2 | Pure water | 97.4 | None | - | EDDS | 0.4 | Sodium octanate | 1.2 | 6.2 | Pionin D-6120 | 1 | A | A | A | B | A | A |
| Example 3 | Pure water | 97.9 | None | - | EDDS | 0.4 | Sodium laurate | 0.7 | 4.5 | Pionin D-6120 | 1 | A | A | A | B | A | A |
| Example 4 | Pure water | 97.4 | None | - | EDDS | 0.4 | Sodium lauryl sulfate | 1.2 | 7.3 | Pionin D-6120 | 1 | A | A | A | B | A | A |
| Example 5 | Pure water | 97.4 | None | - | EDDS | 0.4 | Sodium lauryl sulfonate | 1.2 | 6.5 | Pionin D-6120 | 1 | A | A | A | B | A | A |
| Example 6 | Pure water | 97.4 | None | - | EDDS | 0.4 | Sodium lauryl phosphate | 1.2 | 7.4 | Pionin D-6120 | 1 | A | A | A | B | A | A |
| Example 7 | Pure water | 97.4 | Sodium carbonate | 0.3 | EDDS | 0.4 | Sodium octanate | 1.2 | 6.2 | Pionin D-6120 | 1 | A | A | A | A | A | A |
| Example 8 | Pure water | 97.9 | Sodium carbonate | 0.3 | EDDS | 0.4 | Sodium laurate | 0.7 | 4.5 | Pionin D-6120 | 1 | A | A | B | A | A | A |
| Example 9 | Pure water | 97.9 | Sodium carbonate | 0.3 | EDDS | 0.4 | Sodium laurate | 0.7 | 4.5 | Pionin D-1105 | 1 | A | A | B | A | c | A |
| Example 10 | Pure water | 97.4 | Sodium carbonate | 0.3 | EDDS | 0.4 | Sodium lauryl sulfate | 1.2 | 7.3 | Pionin D-6120 | 1 | A | A | B | A | A | A |

(continued)

| | Composition of aqueous developer | | | | | | | | | | | Concentration suitability (concentration 10 times) | Storage stability | | Developability | Aggregate residue | Coating suppression |
|---|---|---|---|---|---|---|---|---|---|---|---|---|---|---|---|---|---|
| | Water | | Alkali agent | | Chelating agent | | Anionic surfactant | | | Nonionic surfactant | | | | | | | |
| | Type | % by mass | Type | % by mass | Type | % by mass | Type | %by mass | HLB value | Type | % by mass | | 50°C/ 45 davs | -5°C/ 60 davs | | | |
| Example 11 | Pure water | 97.4 | Sodium carbonate | 0.3 | EDDS | 0.4 | Sodium lauryl sulfonate | 1.2 | 6.5 | Pionin D-6120 | 1 | A | A | B | A | A | A |
| Comparative Example 1 | Pure water | 98.4 | None | - | EDDS | 0.4 | Sodium octanate | 1.2 | 6.2 | None | - | D | - | - | B | c | A |
| Comparative Example 2 | Pure water | 98.9 | None | - | EDDS | 0.4 | Sodium laurate | 0.7 | 4.5 | None | - | D | - | - | B | c | A |
| Comparative Example 3 | Pure water | 98.4 | None | - | EDDS | 0.4 | Sodium lauryl sulfate | 1.2 | 7.3 | None | - | D | - | - | B | c | A |
| Comparative Example 4 | Pure water | 98.4 | None | - | EDDS | 0.4 | Sodium lauryl sulfonate | 1.2 | 6.5 | None | - | D | - | - | B | c | A |
| Comparative Example 5 | Pure water | 99.1 | Sodium carbonate | 0.3 | EDDS | 0.4 | None | - | - | Polyoxyethylene nonylphenyl ether | 0.5 | A | c | A | A | A | c |

The following components were used as the components shown in Table 1 above.

- Sodium carbonate: reagent manufactured by FUJIFILM Wako Chemical Corporation
- EDDS: Octaquest E30 (manufactured by Inno Spec specialty chemicals Corporation)
- Sodium pentanate: reagent manufactured by FUJIFILM Wako Chemical Corporation
- Sodium octanate: reagent manufactured by FUJIFILM Wako Chemical Corporation
- Sodium laurate: reagent manufactured by FUJIFILM Wako Chemical Corporation
- Sodium lauryl sulfate: reagent manufactured by FUJIFILM Wako Chemical Corporation
- Sodium lauryl sulfonate: reagent manufactured by FUJIFILM Wako Chemical Corporation
- Sodium lauryl phosphate: reagent manufactured by Tokyo Chemical Industry Co., Ltd.
- Pionin D-6120: polyoxyethylene polystyrylphenyl ether (manufactured by TAKEMOTO OIL & FAT Co., Ltd.)
- Pionin D-1105: polyoxyethylene lauryl ether (manufactured by TAKEMOTO OIL & FAT Co., Ltd.)
- Polyoxyethylene nonylphenyl ether: EMULGEN 905 (manufactured by Kao Corporation)

As shown in Table 1, it was found that, in a case where the nonionic surfactant was not formulated and only the anionic surfactant was formulated, the concentration suitability deteriorated (Comparative Examples 1 to 4).

In addition, it was found that, in a case where the anionic surfactant was not formulated and only the nonionic surfactant was formulated, the storage stability deteriorated (Comparative Example 5).

On the other hand, it was found that, by formulating both the anionic surfactant and the nonionic surfactant, the concentration suitability was excellent and the storage stability was also good (Examples 1 to 11).

In particular, from the comparison between Example 2 and Example 7, and the comparison between Example 3 and Example 8, and the like, it was found that, by formulating the alkali agent, the developability in a case of using the water developer prepared by diluting the concentrated solution was better.

In addition, from the comparison of Examples 1 to 6, it was found that, in a case where the anionic surfactant was the compound represented by Formula (1) described above, the formation of the coating formed on the solution surface of the water developer prepared by diluting the concentrated solution could be suppressed.

In addition, from the comparison between Example 8 and Example 9, it was found that, in a case where the nonionic surfactant was the compound represented by Formula (2) described above, the aggregation of developing residue (dispersion) could be suppressed in the development using the water developer prepared by diluting the concentrated solution.

## Claims

1. An aqueous developer for a flexographic printing plate comprising:

    an anionic surfactant;
    a nonionic surfactant; and
    water,
    wherein the anionic surfactant is a compound represented by Formula (1),

    $$R^1\text{-}X^1 \cdots \qquad (1)$$

    here, in Formula (1),
    $R^1$ represents an alkyl group having 3 to 20 carbon atoms, an alkenyl group having 3 to 20 carbon atoms, or an alkynyl group having 3 to 20 carbon atoms, which may have a substituent, and
    $X^1$ represents a carboxylic acid group or a salt of the carboxylic acid group, a sulfonic acid group or a salt of the sulfonic acid group, a sulfate group or a salt of the sulfate group, or a phosphoric acid group or a salt of the phosphoric acid group.

2. The aqueous developer for a flexographic printing plate according to claim 1,

    wherein a content of the anionic surfactant is 0.01% to 10% by mass, and
    a content of the nonionic surfactant is 0.01% to 10% by mass.

3. The aqueous developer for a flexographic printing plate according to claim 1 or 2, further comprising:
    an alkali agent.

**4.** The aqueous developer for a flexographic printing plate according to any one of claims 1 to 3, wherein $R^1$ in Formula (1) has 6 to 14 carbon atoms.

**5.** The aqueous developer for a flexographic printing plate according to any one of claims 1 to 4, wherein the compound represented by Formula (1) has an HLB value of 8 or less and is water-soluble.

**6.** The aqueous developer for a flexographic printing plate according to any one of claims 1 to 5,

wherein the nonionic surfactant is a compound represented by Formula (2),

$$\left[X^2\right]_p Ar \left[O\left(AO\right)_n R^2\right]_{m-p} \qquad (2)$$

here, in Formula (2),
Ar represents an m-valent aromatic group and m represents an integer of 1 to 8,
$X^2$ represents a monovalent organic group and p represents an integer of 0 to 3,
where p is smaller than m, and in a case where p is 2 or 3, a plurality of $X^2$'s may be the same or different from each other,
A represents an alkylene group having 2 to 4 carbon atoms, $R^2$ represents a hydrogen atom or an alkyl group, and n represents an integer of 1 to 100,
in a case where n is an integer of 2 to 100, a plurality of A's may be the same or different from each other, and in a case where m-p is an integer of 2 to 8, a plurality of A's, n's, and $R^2$'s may all be the same or different from each other.

**7.** A manufacturing method of a flexographic printing plate having a non-image area and an image area, the manufacturing method comprising:

an exposure step of imagewise exposing a photosensitive layer in a flexographic printing plate precursor having the photosensitive layer;
a development step of, after the exposure step, performing development using the aqueous developer for a flexographic printing plate according to any one of claims 1 to 6 to form a non-image area and an image area; and
a rinse step of, after the development step, performing rinsing with water.

**8.** An aqueous developing concentrated solution for a flexographic printing plate, which is a concentrated solution of an aqueous developer for a flexographic printing plate, comprising:

an anionic surfactant;
a nonionic surfactant; and
water.

**9.** The aqueous developing concentrated solution for a flexographic printing plate according to claim 8,

wherein a content of the anionic surfactant is 0.02% to 40% by mass, and
a content of the nonionic surfactant is 0.02% to 40% by mass.

**10.** The aqueous developing concentrated solution for a flexographic printing plate according to claim 8 or 9, further comprising:
an alkali agent.

**11.** The aqueous developing concentrated solution for a flexographic printing plate according to any one of claims 8 to 10,

wherein the anionic surfactant is a compound represented by Formula (1),

$$R^1\text{-}X^1 \cdots \qquad (1)$$

here, in Formula (1),
$R^1$ represents an alkyl group having 3 to 20 carbon atoms, an alkenyl group having 3 to 20 carbon atoms, or an alkynyl group having 3 to 20 carbon atoms, which may have a substituent, and
$X^1$ represents a carboxylic acid group or a salt of the carboxylic acid group, a sulfonic acid group or a salt of the sulfonic acid group, a sulfate group or a salt of the sulfate group, or a phosphoric acid group or a salt of the phosphoric acid group.

**12.** The aqueous developing concentrated solution for a flexographic printing plate according to claim 11, wherein $R^1$ in Formula (1) has 6 to 14 carbon atoms.

**13.** The aqueous developing concentrated solution for a flexographic printing plate according to claim 11 or 12, wherein the compound represented by Formula (1) has an HLB value of 8 or less and is water-soluble.

**14.** The aqueous developing concentrated solution for a flexographic printing plate according to any one of claims 8 to 13,

wherein the nonionic surfactant is a compound represented by Formula (2),

$$\left[X^2\right]_p Ar \left[O \left(AO\right)_n R^2\right]_{m-p} \qquad (2)$$

here, in Formula (2),
Ar represents an m-valent aromatic group and m represents an integer of 1 to 8,
$X^2$ represents a monovalent organic group and p represents an integer of 0 to 3,
where p is smaller than m, and in a case where p is 2 or 3, a plurality of $X^2$'s may be the same or different from each other,
A represents an alkylene group having 2 to 4 carbon atoms, $R^2$ represents a hydrogen atom or an alkyl group, and n represents an integer of 1 to 100,
in a case where n is an integer of 2 to 100, a plurality of A's may be the same or different from each other, and in a case where m-p is an integer of 2 to 8, a plurality of A's, n's, and $R^2$'s may all be the same or different from each other.

**15.** A manufacturing method of a flexographic printing plate having a non-image area and an image area, the manufacturing method comprising:

an exposure step of imagewise exposing a photosensitive layer in a flexographic printing plate precursor having the photosensitive layer;
a development step of, after the exposure step, performing development using a solution obtained by diluting the aqueous developing concentrated solution for a flexographic printing plate according to any one of claims 8 to 14 by 2 to 20 times to form a non-image area and an image area; and
a rinse step of, after the development step, performing rinsing with water.

## INTERNATIONAL SEARCH REPORT

International application No.
PCT/JP2020/041504

A. CLASSIFICATION OF SUBJECT MATTER
B41C 1/00(2006.01)i; G03F 7/00(2006.01)i; G03F 7/32(2006.01)i
FI: G03F7/32; G03F7/00 502; B41C1/00
According to International Patent Classification (IPC) or to both national classification and IPC

B. FIELDS SEARCHED
Minimum documentation searched (classification system followed by classification symbols)
B41C1/00; G03F7/00; G03F7/32

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2013-156361 A (ASAHI KASEI E-MATERIALS CORP.) 15 August 2013 (2013-08-15) paragraph [0071] | 1-15 |
| Y<br>A | JP 2003-241398 A (TORAY INDUSTRIES, INC.) 27 August 2003 (2003-08-27) claims, example 1 | 1-7, 11-13<br>8-10, 14-15 |
| Y | JP 2018-120128 A (ASAHI KASEI CORPORATION) 02 August 2018 (2018-08-02) claims, paragraph [0139] | 3 |
| Y | JP 7-301920 A (TOYOBO BOSEKI KABUSHIKI KAISHA) 14 November 1995 (1995-11-14) paragraph [0032], example 5 | 6 |

☒ Further documents are listed in the continuation of Box C.   ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 January 2021 (07.01.2021) | 26 January 2021 (26.01.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2020/041504

C (Continuation). DOCUMENTS CONSIDERED TO BE RELEVANT

| Category* | Citation of document, with indication, where appropriate, of the relevant passages | Relevant to claim No. |
|---|---|---|
| Y | JP 7-209880 A (DAINIPPON INK AND CHEMICALS, INCORPORATED) 11 August 1995 (1995-08-11) claims, paragraphs [0002], [0027], [0035], [0129], developer 9 | 8-15 |
| A | JP 2009-91578 A (BAYER MATERIALSCIENCE LLC) 30 April 2009 (2009-04-30) paragraph [0020] | 8-15 |

Form PCT/ISA/210 (continuation of second sheet) (January 2015)

**INTERNATIONAL SEARCH REPORT**

International application No.
PCT/JP2020/041504

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:
See extra sheet

1. ☒ As all required additional search fees were timely paid by the applicant, this international search report covers all searchable claims.
2. ☐ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☒ No protest accompanied the payment of additional search fees.

Form PCT/ISA/210 (continuation of first sheet (2)) (January 2015)

**INTERNATIONAL SEARCH REPORT**
Information on patent family members

International application No.
PCT/JP2020/041504

| Patent Documents referred in the Report | Publication Date | Patent Family | Publication Date |
|---|---|---|---|
| JP 2013-156361 A | 15 Aug. 2013 | (Family: none) | |
| JP 2003-241398 A | 27 Aug. 2003 | (Family: none) | |
| JP 2018-120128 A | 02 Aug. 2018 | (Family: none) | |
| JP 7-301920 A | 14 Nov. 1995 | (Family: none) | |
| JP 7-209880 A | 11 Aug. 1995 | (Family: none) | |
| JP 2009-91578 A | 30 Apr. 2009 | US 2009/0089942 A1<br>paragraph [0035]<br>CN 101408002 A<br>KR 10-2009-0036514 A<br>TW 200932796 A | |

Form PCT/ISA/210 (patent family annex) (January 2015)

**INTERNATIONAL SEARCH REPORT**

International application No.
PCT/JP2020/041504

<Continuation of Box No. III>

(Invention 1) Claims 1-7

Claims 1-7 have the special technical feature of an aqueous developing solution for flexographic printing plates set forth in claim 1, and are thus classified as invention 1.

(Invention 2) Claims 8-15

Claim 8 has a corresponding technical feature with claim 1 classified as invention 1, that is, an aqueous developing solution for flexographic printing plates containing anionic surfactants, nonionic surfactants, and water.

However, this technical feature does not make a contribution over the prior art in light of the disclosure of document 1, and thus cannot be considered a special technical feature.

Furthermore, there are no other identical or corresponding special technical features between these inventions. In addition, claims 8-15 are not dependent on claim 1. Also, claims 8-15 are not substantially identical or equivalent to any of the claims classified as invention 1.

Therefore, claims 8-15 cannot be classified as invention 1.

In addition, claims 8-15 have the special technical feature of concentrate of an aqueous developing solution for flexographic printing plates set forth in claim 8, and are thus classified as invention 2.

Document 1: JP 2013-156361 A (ASAHI KASEI E-MATERIALS CORP.) 15 August 2013 (2013-08-15) paragraph [0071] (Family: none)

Form PCT/ISA/210 (extra sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2012111238 A